# EUROPEAN PATENT APPLICATION

(11) **EP 2 975 452 A1**
(43) Date of publication of application: **20.01.2016**
(21) Application number: 15175546.9
(22) Date of filing: 06.07.2015
(51) Int. Cl.: G02F 1/1335, H01L 27/15, H05K 1/02, H05K 7/20, F21V 29/10

(54) **BACKLIGHT DEVICE**

(30) Priority: 17.07.2014 TW 103124468; 17.06.2015 TW 104119576
(71) Applicant: Lee, Cheng-Tao, Kaohsiung City (TW)
(72) Inventor: Lee, Cheng-Tao, Kaohsiung City (TW)
(74) Representative: Lang, Christian

(57) **Abstract**

A backlight device includes a backboard (1) having a first portion (11) and a second portion (12). The second portion (12) is mounted to an outer periphery of the first portion (11). The first portion (11) and the second portion (12) together define a light mixing chamber (S). An insulating layer (13) is formed on a surface of the first portion (11) in the light mixing chamber (S) or a surface of the second portion (12) in the light mixing chamber (S). A lighting module (2) includes at least one conductive circuit (21) and at least one light-emitting diode (22) electrically connected to the at least one conductive circuit (21). The at least one conductive circuit (21) is formed on the insulating layer (13). An optical module (3) is mounted to the backboard (1) and is located in a top of the light mixing chamber (S).

## Description

### BACKGROUND OF THE INVENTION

### 1. Field of the Invention

The present invention relates to a backlight device for a display and, more particularly, to a backlight device that can provide an increased heat transfer rate and a light, thinned structure and that can reduce the assembly time.

### 2. Description of the Related Art

Miniaturized high-illuminance light sources, such as light-emitting diodes (LEDs), have been widely used in various backlight devices from cell phone screens to large-size television screens in recent years.

Edge-lit backlight modules were generally used in early backlight devices. With the increase in the demand of large-size television screens, direct-lit backlight modules have been developed to increase the picture quality of the large-size screen.

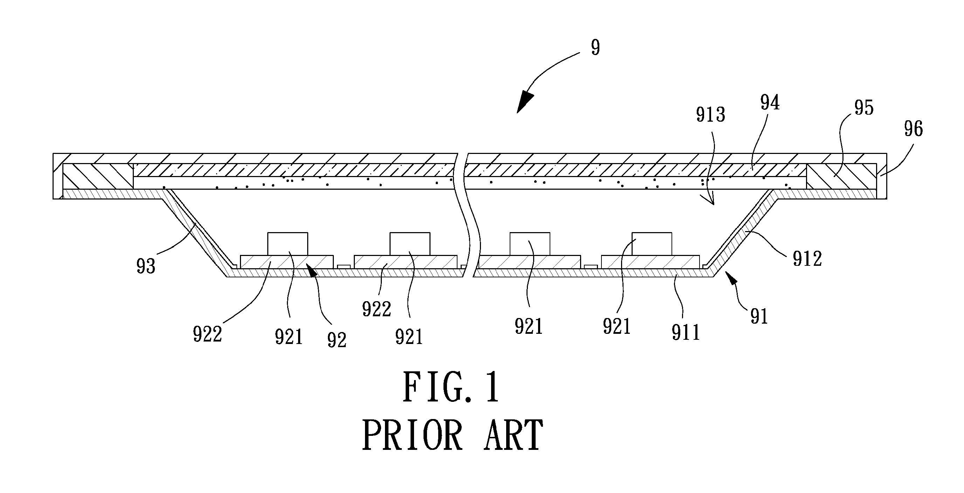

FIG. 1 shows a conventional backlight device 9 for a direct-lit backlight module. The conventional backlight device 9 includes a backboard 91. The backboard 91 includes a horizontal bottom 911 and an inclined sidewall 912 connected to an outer periphery of the bottom 911. The bottom 911 and the sidewall 912 together define a light mixing chamber 913.

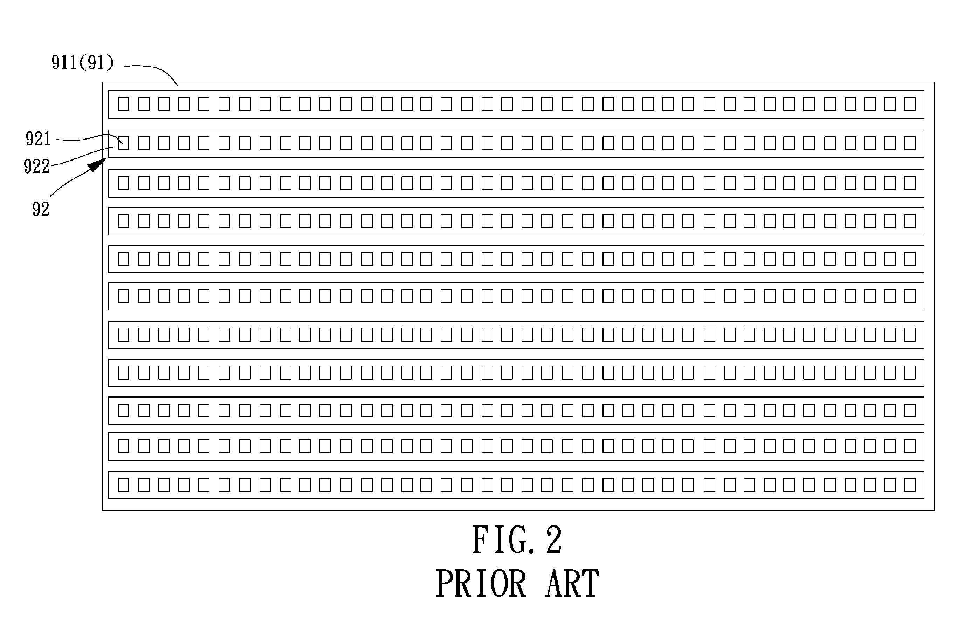

The conventional backlight device 9 further includes a plurality of direct-lit lighting modules 92 mounted in the light mixing chamber 913. With reference to FIG. 2, each direct-lit lighting module 92 bonds a row of light-emitting diodes 921 on a strip-shaped circuit board 922, and the strip-shaped circuit boards 922 are mounted to an inner side of the bottom 911 of the backboard 91.

With reference to FIG. 1, the conventional backlight device 9 includes a reflective layer 93 in the light mixing chamber 913. One or more layer of optical films 94 are provided at a top of the light mixing chamber 913. A support portion 95 is provided on each of two sides of the optical films 94. A frame 96 is used to package the optical films 94. A liquid crystal panel (not shown) is mounted on the frame 96. The conventional backlight device 9 is used as a backlight source of the liquid crystal panel.

The light-emitting diodes 921 can be arranged on the back side of the liquid crystal panel. When the light-emitting diodes 921 operate, the light rays can be mixed in the light mixing chamber 913 and then projected onto the liquid crystal panel to provide a uniform light distribution throughout the liquid crystal panel, increasing the picture quality. Examples of the conventional backlight device 9 have been disclosed in Taiwan Utility Model No. M479438 entitled "BACKLIGHT MODULE FOR LED TV", Taiwan Publication No. I422783 entitled "DIRECT-LIT LIGHT-EMITTING DIODE LIGHT SOURCE", Taiwan Utility Model No. M371308 entitled "LIGHT-EMITTING DIODE MODULE", and U.S. Patent No. 7,588,362 entitled "BACKLIGHT ASSEMBLY, DISPLAY DEVICE PROVIDED WITH THE SAME, AND METHOD FOR ASSEMBLING BACKLIGHT ASSEMBLY".

The service life of the light-emitting diodes 921 is related to the working temperature. Excessively high working temperature will cause rapid shortening of the service life of the light-emitting diodes 921. Thus, the heat energy generated during operation of the light-emitting diodes 921 must be transferred to the circuit boards 922 as soon as possible and then transferred to the backboard 91 to expel the heat energy, thereby maintaining a suitable working temperature for the light-emitting diodes 921. However, the thickness of the circuit boards 922 is generally about 0.8-3 mm, and the thermal conductivity of the material of the circuit boards 922 is poor, such that the heat transfer through the circuit boards 922 to the backboard 91 is not efficient.

Furthermore, to assure tight connection between the circuit boards 922 and the backboard 91 and to avoid the airs in the gaps from adversely affecting the heat transfer effect, after bonding the light-emitting diodes 921 to the circuit boards 922, fixing mechanisms, such as screws, back glue, snap fasteners, etc., are selectively used to tightly fix the circuit boards 922 to the backboard 91 of the conventional backlight device 9. The fixing mechanisms (no matter which type is used) must be densely arranged and, thus, have a considerable number, leading to high material costs and long assembly time. Furthermore, the weight and thickness of the circuit boards 922 cause difficulties in obtaining a light, thin structure for the conventional backlight device 9. Furthermore, fixing holes or positioning structures for the fixing mechanisms must be preserved in the circuit boards 922, and corresponding snap fasteners or locking holes must be preserved in corresponding locations in the backboard 91, leading to extra manufacturing costs of the circuit boards 922 and the backboard 91.

Thus, improvement to the conventional backlight device 9 is desired.

### SUMMARY OF THE INVENTION

The present invention provides a backlight device permitting a conductive circuit of a lighting module to be directly formed on an insulating layer of a backboard, such that the heat energy generated by a light-emitting diode on the conductive circuit can be transferred to the backboard with high effectiveness, greatly increasing the heat dissipating efficiency of the light-emitting diode and effectively reducing the overall weight and the overall thickness of the backlight device.

A backlight device according to the present invention includes a backboard having a first portion and a second portion. The second portion is mounted to an outer periphery of the first portion. The first portion and the second portion together define a light mixing chamber. An insulating layer is formed on a surface of the first portion in the light mixing chamber or a surface of the second portion in the light mixing chamber. A lighting module includes at least one conductive circuit and at least one light-emitting diode electrically connected to the at least one conductive circuit. The at least one conductive circuit is formed on the insulating layer. An optical module is mounted to the backboard and is located in a top of the light mixing chamber.

In an example, the insulating layer is disposed on first portion to form a direct-lit backlight device.

In an example, the first portion is not plane, such as of a curved type.

The second portion can extend beyond the outer periphery of the first portion.

The backboard 1 can include a reflective layer on at least one surface in the light mixing chamber, and the at least one light-emitting diode extends beyond the reflective layer.

In a further example, the backlight device further includes a light guiding plate mounted in the light mixing chamber. The insulating layer is disposed on the second portion. The light guiding plate is located on a lighting side of the at least one light-emitting diode to form an edge-lit backlight device.

The lighting module can include at least one functional electronic component electrically connected to the at least one conductive circuit. The at least one functional electronic component can be an electronic circuit element for driving the at least one light-emitting diode to operate.

The first portion and the second portion of the backboard can be manufactured separately and then assembled.

The first portion and the second portion can be made of different materials.

In still another example, the outer periphery of the first portion is fitted in the second portion.

Thus, in the backlight device according to the present invention, the at least one conductive circuit of the lighting module is formed on the insulating layer which has a thickness of about *µ* m that is far smaller than the thickness of the circuit board used in the conventional backlight device. Thus, the heat transfer impedance from the insulating layer to the backboard can be greatly reduced, such that the heat energy generated during operation of the at least one light-emitting diode on the at least one conductive circuit can be rapidly transferred to the backboard with high effectiveness, greatly increasing the heat dissipating efficiency of the at least one light-emitting diode. Thus, the service life of the at least one light-emitting diode can be prolonged while permitting the at least one light-emitting diode to operate at a higher power without the concern of high working temperature. Furthermore, since the backlight device according to the present invention does not have to use circuit boards and the fixing mechanism (such as screws, back glue, snap fasteners, etc.), the material costs of the backlight device can be effectively reduced to increase the assembly efficiency while reducing the weight of the backlight device and thinning the backlight device.

The present invention will become clearer in light of the following detailed description of illustrative embodiments of this invention described in connection with the drawings.

### BRIEF DESCRIPTION OF THE DRAWINGS

FIG. 1 is a cross sectional view of a conventional backlight device.
FIG. 2 is a top view of the conventional backlight device.
FIG. 3 is a cross sectional view of a backlight device of a first embodiment according to the present invention.
FIG. 4 is a partial, perspective view of the backlight device of the first embodiment according to the present invention.
FIG. 5 is a cross sectional view of another example of the backlight device of the first embodiment according to the present invention, with the backlight device having a curved backboard.
FIG. 6 is a cross sectional view of a further example of the backlight device of the first embodiment according to the present invention.
FIG. 7 is a cross sectional view of still another example of the backlight device of the first embodiment according to the present invention, with the backlight device having a combination type backboard.
FIG. 8 is a cross sectional view of a backlight device of a second embodiment according to the present invention.

### DETAILED DESCRIPTION OF THE INVENTION

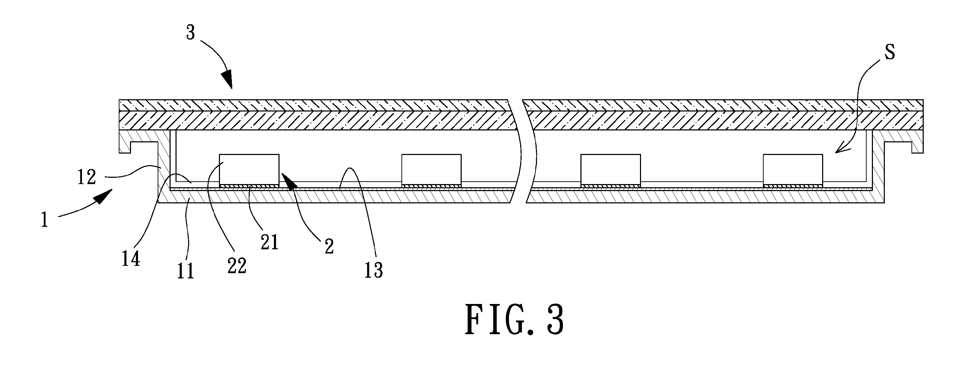

FIG. 3 shows a backlight device of a first embodiment according to the present invention. The backlight device includes a backboard 1, a lighting module 2, and an optical module 3. The lighting module 2 and the optical module 3 are mounted to the backboard 1.

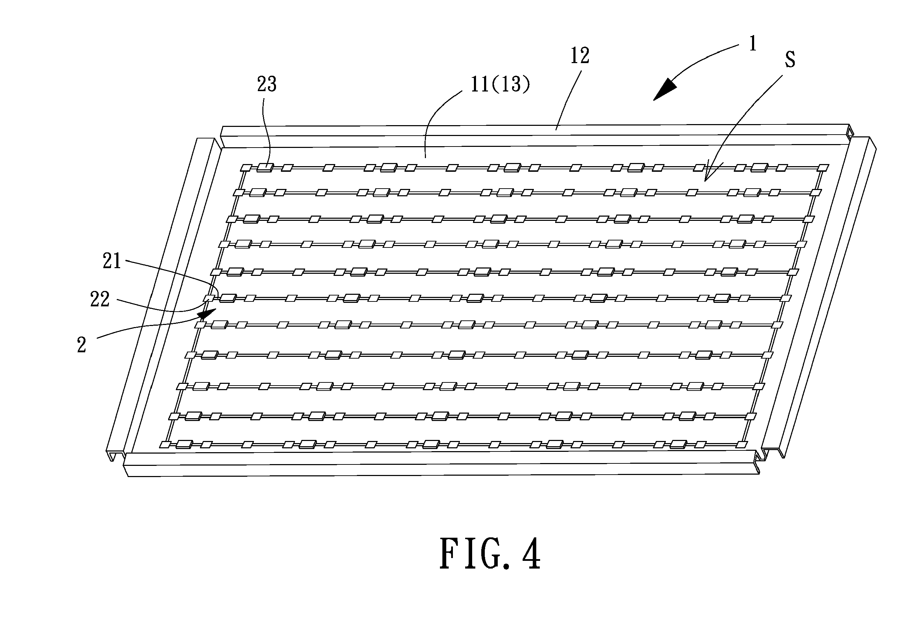

With reference to FIGS. 3 and 4, the backboard 1 includes a first portion 11 and a second portion 12. The second portion 12 is mounted to an outer periphery of the first portion 11 to form a three-dimensional structure for the backboard 1 while providing a sufficient structural strength that does not deform easily. The first portion 11 and the second portion 12 can be connected in a coplanar manner. After mounting the lighting module 2 to the backboard 1, the second portion 12 is bent relative to the first portion 11 to form the three-dimensional structure of the backboard 1. Alternatively, the first portion 11 and the second portion 12 can be directly connected in a non-coplanar manner to form the three-dimensional structure of the backboard 1 for mounting the lighting module 2.

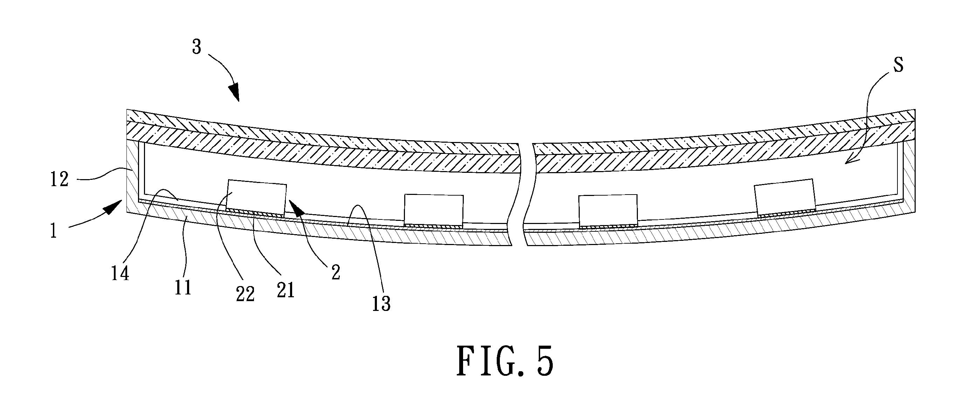

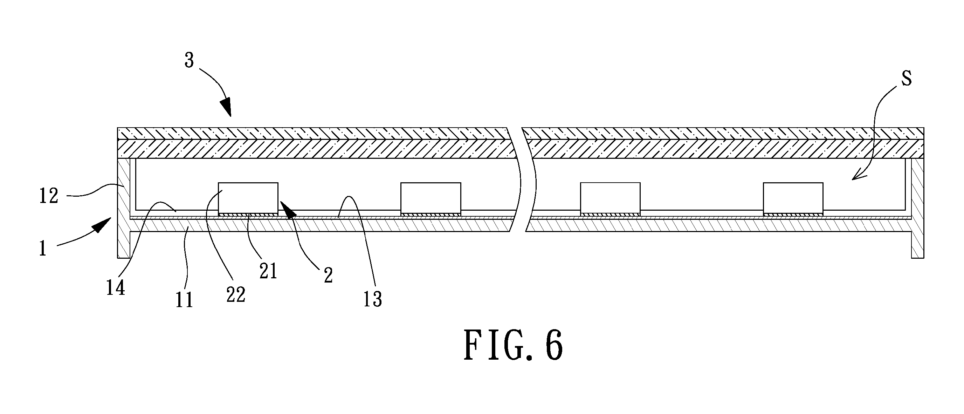

The first portion 11 can be plane (see FIG. 3), non-plane (such as a curved type shown in FIG. 5), or of a type including a plurality of planes connected in an inclined manner. The type of the second portion 12 is not limited. For example, the second portion 12 can be an annular wall extending perpendicularly to the first portion 11 or an inclined annular wall. Furthermore, the second portion 12 can extend beyond the outer periphery o the first portion 11 (see FIG. 6) to define a heat dissipating space on the back side of the backboard 1.

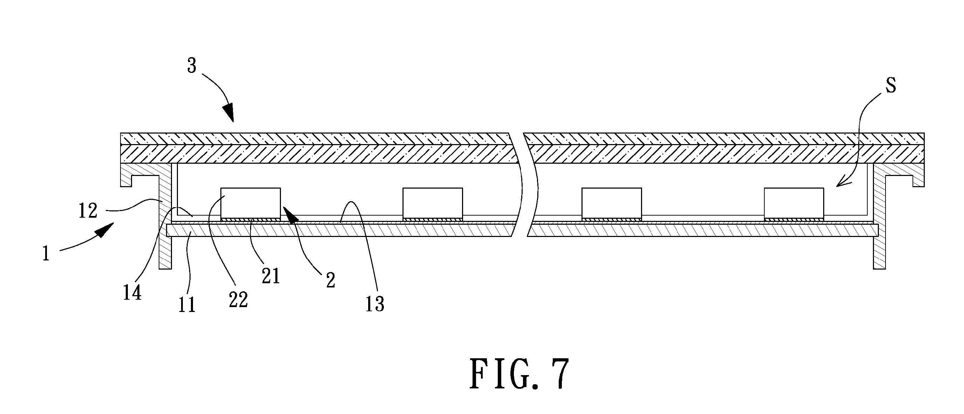

The first portion 11 and the second portion 12 can be integrally formed with each other or two separate members combined to each other. The materials for the first portion 11 and the second portion 12 can be the same or different from each other. For example, as shown in FIG. 7, the backboard 1 is of a combination type; namely, the first portion 11 and the second portion 12 of the backboard 1 can be manufactured separately and then assembled. Furthermore, the first portion 11 or the second portion 12 can be divided into a plurality of portions, and the portions can be manufactured separately. The coupling between the portions of the backboard 1 can be, but not limited to, locking, bonding, and welding. The features of the backboard 1 of combination type are that each portion of the backboard 1 has a small volume. Compared to the backboard 1 of integral type, the backboard 1 of combination type can greatly reduce the costs for molds. Furthermore, the backboard 1 of combination type can select the desired materials according to the needs of the portions. For example, the first portion 11 can be made of aluminum which is better in heat dissipation, and the second portion 12 can be made of a steel material with a strong structural strength or made of a lightweight plastic material. Furthermore, in the embodiment shown in FIG. 7, the outer periphery of the first portion 11 is fitted in the second portion 12. No matter whether the first portion 11 and the second portion 12 are made of the same material, the bonding reliability between the first portion 11 and the second portion 12 can be further improved.

With reference to FIGS. 3 and 4, the first portion 11 and the second portion 12 together defines a light mixing chamber "S". An insulating layer 13 is formed on a surface of the first portion 11 in the light mixing chamber "S" or a surface of the second portion 12 in the light mixing chamber "S." In a case that the backboard 1 can be made of an electrically conductive material, the insulating layer 13 can be an insulating medium coated on a face of the backboard 1. The distribution area of the insulating layer 13 can match with the pattern of the conductive circuit 21, rather than an integral insulating layer 13 on the whole face of the first portion 11 or the second portion 12. Thus, by arranging the insulating layer 13 corresponding to the pattern of the conductive circuit 21, the amount of the insulating layer 13 can be greatly reduced to reduce the manufacturing costs. In another case that the backboard 1 is made of a non-conductive material, the insulating layer 13 is not necessary, which can be appreciated by one having ordinary skill in the art. Furthermore, the backboard 1 can further include a reflective layer 14 on at least one surface in the light mixing chamber "S." The reflective layer 14 can be bonded or applied to the insulating layer 13.

The lighting module 2 includes at least one conductive circuit 21 and at least one light-emitting diode 22 electrically connected to the at least one conductive circuit 21. The at least one conductive circuit 21 is formed on the insulating layer 13. The at least one light-emitting diode 22 extends beyond the reflective layer 14. The lighting module 2 can further include at least one functional electronic component 23 electrically connected to the at least one conductive circuit 21. The at least one functional electronic component 23 can be an electronic circuit element for driving the at least one light-emitting diode 22 to operate.

The optical module 3 can transform the optical characteristics and is mainly used to convert the light rays (produced by the lighting module 2 after light mixing in the light mixing chamber "S") into the desired light distribution of the backlight device or to generate a uniform lighting effect. The detailed structure and principle of the optical module 3 can be appreciated by a person having ordinary skill in the art and are, thus, not described in details, because they are not the main features of the present invention. In this embodiment, the optical module 3 can be coupled to the backboard 1, such as using a housing (not shown) to press against the optical module 3, and the optical module 3 is located in a top of the light mixing chamber "S."

According to the above structure of the backlight device according to the present invention, the at least one conductive circuit 21 of the lighting module 2 is formed on the insulating layer 13 which has a thickness of about 40-150 *µ*m that is far smaller than the thickness of the circuit board 922 (FIG. 1) used in the conventional backlight device. Thus, the heat transfer impedance from the insulating layer 13 to the backboard 1 can be greatly reduced, such that the heat energy generated during operation of the at least one light-emitting diode 22 on the at least one conductive circuit 21 can be rapidly transferred to the backboard 1 for rapid heat dissipation, greatly increasing the heat dissipating efficiency of the at least one light-emitting diode 22. Thus, the service life of the at least one light-emitting diode 22 can be prolonged while permitting the at least one light-emitting diode 22 to operate at a higher power without the concern of high working temperature.

Furthermore, since the backlight device according to the present invention does not have to use circuit boards and the fixing mechanism (such as screws, back glue, snap fasteners, etc.), the material costs of the backlight device can be effectively reduced to increase the assembly efficiency and to effectively reduce the overall weight and the overall thickness of the backlight device. Thus, the backlight device can have a light weight and can be thinned. Furthermore, the backboard 1 of the backlight device according to the present invention does not have to preserve the snap fasteners or the locking holes for the fixing mechanisms, reducing the manufacturing costs.

In this embodiment, the insulating layer 13 is disposed on first portion 11 to cooperate with the lighting module 2 and the optical module 3 to form a direct-lit backlight device, which is particularly suitable to be mounted to a back side of a large-size liquid crystal panel while highlighting the advantages of the backlight device according to the present invention.

Particularly, taking a backlight device for use in a 32 inch screen, the light mixing chamber "S" of the backlight device according to the present invention has a length of about 709mm, a width of about 400mm, and a height of about 20mm, the backboard 1 can be a steel board having a thickness of 0.8mm and having a density of about 7.8g/cm³, and the overall weight of the backboard 1 is about 2.11kg. By contrast, in a backlight device produced according to the prior art, if the circuit board uses FR-4 epoxy glass fabric laminate having a thickness of 1mm and having a density of about 1.8g/cm³ and covers the whole surface of the first portion of the backboard, the overall weight of the circuit board is about 0.51kg. Thus, the overall weight of the backlight device according to the prior art (the sum of the weight of the backboard and the weight of the circuit board) is 2.62kg. Thus, the backlight device according to the present invention can save the weight by about 20%.

Furthermore, in the backlight device according to the prior art, since the circuit board requires the fixing mechanisms (such as screws, back glue, snap fasteners, etc.), it is difficult to make the gap between two adjacent light-emitting diodes smaller than 30mm and, thus, difficult to make the height of the light mixing chamber smaller than 20mm. By contrast, the backlight device according to the present invention without the limitation of the fixing mechanisms permits significant reduction in the spacing between two adjacent light-emitting diodes 22. For example, when the spacing between two adjacent light-emitting diodes 22 is 15mm, the height of the light mixing chamber "S" can be reduced to 14mm, reducing the height of the light mixing chamber "S" by about 30% while maintaining excellent light mixing effect.

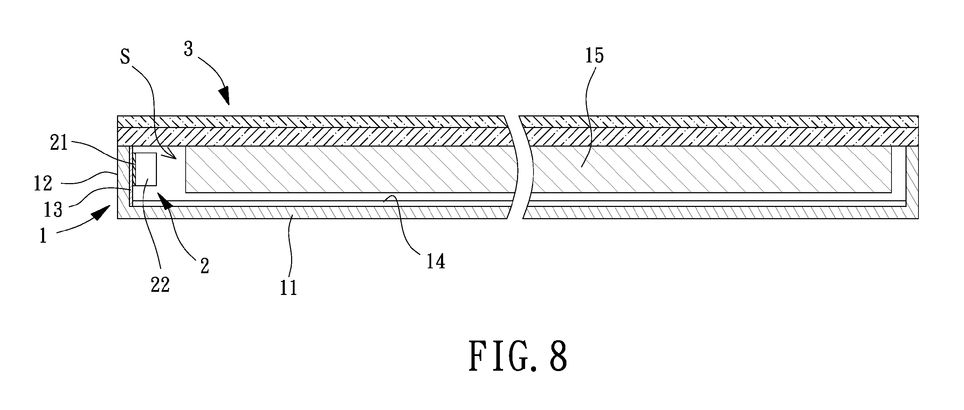

FIG. 8 shows a backlight device of a second embodiment according to the present invention which is substantially the same as the first embodiment. The main difference is that the insulating layer 13 is disposed on the second portion 12 in this embodiment, and a light guiding plate 15 is mounted in the light mixing chamber "S" to cooperate with the lighting module 2 and the optical module 3 to form an edge-lit backlight device.

Specifically, since the insulating layer 13 is disposed on the second portion 12 in this embodiment and since the light guiding plate 15 is located on a lighting side of the at least one light-emitting diode 22 electrically connected to the at least one conductive circuit 21 which, in turn, is disposed on the insulating layer 13, the light ray generated during operation of the at least one light-emitting diode 22 can be incident on the light guiding plate 15 from the edge of the at least one light-emitting diode 22, and the light guiding plate 15 uniformly guides the light rays to the optical module 3. The backlight device of this embodiment is more suitable to electronic devices having a small-size liquid crystal panel, such as cell phones, tablets, or notebooks.

In view of the foregoing, the backlight device according to the present invention permits the at least one conductive circuit 21 of the lighting module 2 to be directly formed on the insulating layer 13 on the backboard 1, such that the heat transfer impedance from the insulating layer 13 to the backboard 1 can be greatly reduced. Thus, the heat energy generated during operation of the at least one light-emitting diode 22 on the at least one conductive circuit 21 can be transferred to the backboard 1 with high effectiveness, greatly increasing the heat dissipating efficiency of the at least one light-emitting diode 22, prolonging the service life of the at least one light-emitting diode 22, reducing the material costs of the backlight device, and increasing the assembly efficiency while reducing the weight of the backlight device and thinning the backlight device.

Thus since the invention disclosed herein may be embodied in other specific forms without departing from the spirit or general characteristics thereof, some of which forms have been indicated, the embodiments described herein are to be considered in all respects illustrative and not restrictive. The scope of the invention is to be indicated by the appended claims, rather than by the foregoing description, and all changes which come within the meaning and range of equivalency of the claims are intended to be embraced therein.

## Claims

1. A backlight device comprising:
a backboard (1) including a first portion (11) and a second portion (12), with the second portion (12) mounted to an outer periphery of the first portion (11), and with the first portion (11) and the second portion (12) together defining a light mixing chamber (S);
a lighting module (2) including at least one conductive circuit (21) and at least one light-emitting diode (22) electrically connected to the at least one conductive circuit (21); and
an optical module (3) mounted to the backboard (1) and located in a top of the light mixing chamber (S),
wherein the backlight device is **characterized in that** an insulating layer (13) is formed on a surface of the first portion (11) in the light mixing chamber (S) or a surface of the second portion (12) in the light mixing chamber (S), and the at least one conductive circuit (21) is formed on the insulating layer (13).

2. The backlight device as claimed in claim 1, **characterized in that** the insulating layer (13) is disposed on the first portion (11).

3. The backlight device as claimed in claim 1, **characterized in that** the first portion (11) is not plane.

4. The backlight device as claimed in claim 1, **characterized in** further comprising a light guiding plate (15) mounted in the light mixing chamber (S), with the insulating layer (13) disposed on the second portion (12), and with the light guiding plate (15) located on a lighting side of the at least one light-emitting diode (22).

5. The backlight device as claimed in claim 1, **characterized in that** the second portion (12) extends beyond the outer periphery of the first portion (11).

6. The backlight device as claimed in claim 1, **characterized in that** the backboard (1) includes a reflective layer (14) on at least one surface in the light mixing chamber (S), wherein the at least one light-emitting diode (22) extends beyond the reflective layer (14).

7. The backlight device as claimed in claim 1, **characterized in that** the lighting module (2) includes at least one functional electronic component (23) electrically connected to the at least one conductive circuit (21).

8. The backlight device as claimed in claim 1, **characterized in that** the first portion (11) and the second portion (12) of the backboard (1) are manufactured separately and then assembled.

9. The backlight device as claimed in claim 8, **characterized in that** the first portion (11) and the second portion (12) are made of different materials.

10. The backlight device as claimed in claim 8, **characterized in that** the outer periphery of the first portion (11) is fitted in the second portion (12).
